# EUROPÄISCHE PATENTSCHRIFT

(11) **EP 2 019 812 B1**
(45) Veröffentlichungstag und Bekanntmachung des Hinweises auf die Patenterteilung: **21.03.2012**
(21) Anmeldenummer: 07727692.1
(22) Anmeldetag: 03.04.2007
(51) Int. Cl.: B81C 1/00, H04R 19/04

(54) **VERFAHREN ZUR HERSTELLUNG EINES MIKROMECHANISCHEN BAUELEMENTS MIT MEMBRAN UND MIKROMECHANISCHES BAUELEMENT**
METHOD FOR PRODUCING A MICROMECHANICAL COMPONENT HAVING A MEMBRANE AND MICROMECHANICAL COMPONENT
PROCÉDÉ DE FABRICATION D'UN ÉLÉMENT MICROMÉCANIQUE AYANT UNE MEMBRANE ET ÉLÉMENT MICROMÉCANIQUE

(30) Priorität: 12.05.2006 DE 102006022378
(43) Veröffentlichungstag der Anmeldung: 04.02.2009
(73) Patentinhaber: Robert Bosch GmbH, 70442 Stuttgart (DE)
(72) Erfinder: WEBER, Heribert, 72622 Nuertingen (DE); SCHELLING, Christoph, 70597 Stuttgart (DE); SCHLOSSER, Roman, 72770 Reutlingen (DE)
(86) Internationale Anmeldenummer: PCT/EP2007/053221
(87) Internationale Veröffentlichungsnummer: WO 2007/131836

(56) Entgegenhaltungen:
- EP-A- 1 648 195
- DE-A1- 10 206 711
- DE-A1-102004 015 444
- US-A1- 2002 093 038
- SCHMID P ET AL: "Plasma deposition of Si-N and Si-O passivation layers on three-dimensional sensor devices" SURFACE AND COATINGS TECHNOLOGY ELSEVIER SWITZERLAND, Bd. 98, Nr. 1-3, Januar 1998 (1998-01), Seiten 1510-1517, XP002444452 ISSN: 0257-8972

## Beschreibung

### Stand der Technik

Die Erfindung geht aus von einem Verfahren zur Herstellung eines mikromechanischen Bauelements und von einem mikromechanischen Bauelement gemäß den Oberbegriffen der nebengeordneten Ansprüche.

Ein Verfahren zur Herstellung einer akustischen Struktur auf einem Substrat ist aus der europäischen Patentanmeldung EP 1 441 561 A2 bekannt. Hierbei wird eine Membran oberhalb eines Substratmaterials dadurch hergestellt, dass durch die Membran hindurch zwischen der Membran und dem Substrat ein Freiraum geätzt wird, wobei der Membranabstand über einen Ätzvorgang ohne Endpunkt bzw. Ätzbegrenzung vorgesehen ist. Hieran ist nachteilig, dass der Elektrodenabstand der Kondensatoranordnung, die zwischen der Membran und dem Substrat gebildet wird, nur sehr schlecht definiert ist, so dass zum einen der Membranabstand nur sehr ungenau vorgebbar ist und zum anderen ein vergleichsweise großer Membranabstand vorgesehen sein muss, der dazu führt, dass das aus der Kondensatoranordnung ableitbare Signal vergleichsweise klein ist bzw. die Empfindlichkeit gering ist.

Ein weiteres Verfahren zur Herstellung eines mikromechanischen Elements mit einer Membranstruktur wird in der veröffentlichten US-Patentanmeldung US2002/093038 A1 beschrieben. Ein leitfähiger Substratbereich bildet eine erste Elektrode über der nacheinander eine Passivierungsschicht, ein organisches Opferschichtmaterial, eine weitere Passivierungsschicht und eine leitfähige Schicht erzeugt werden. Durch eine in die Rückseite des Substrats geätzte Ausnehmung wird das Opferschichtmaterial mit einem Sauerstoffplasma entfernt, so dass eine Membran mit einer zweiten Elektrode entsteht.

### Offenbarung der Erfindung

Das erfindungsgemäße Verfahren zur Herstellung eines mikromechanischen Bauelements und das mikromechanische Bauelement gemäß den nebengeordneten Ansprüchen hat den Vorteil, dass die Membranstruktur zum einen eine sehr dünne Membran aufweisen kann, die darüber hinaus in einem vergleichsweise geringen Abstand zu einem Teilbereich des Substrats angeordnet sein kann, so dass hinsichtlich der Elektrodenabstände der Kondensatoranordnung besonders kleine Distanzen realisierbar sind. Ferner ist es erfindungsgemäß besonders vorteilhaft, dass der Abstand der Membranstruktur von dem Substratmaterial bzw. dem Substrat besonders genau eingestellt werden kann und besonders exakt reproduzierbar bzw. vorwählbar ist sowie planparallele. Elektrodenflächen geschaffen werden können. Erfindungsgemäss wird ferner nach jedem Ätzschritt, bei dem Substratmaterial entfernt wird, eine Passivierungsschicht zum Schutz der freigelegten Substratwände abgeschieden . Unter den Substratwänden wird hierbei im wesentlichen senkrecht zur Haupterstreckungsebene der Membranstruktur verlaufende Bereiche des Substrats verstanden.

Erfindungsgemäß wird die Opferstruktur in oder auf eine erste Seite des Substrats ein- oder aufgebracht, wobei die Opferstruktur mittels eines Ätzschrittes von einer der ersten Seite gegenüberliegenden zweiten Seite des Substrats entfernt wird. Hierdurch ist es möglich, dass die Membranstruktur im wesentlichen durchgehend ausgebildet ist, d.h. keine Löcher bzw. Ausnehmungen aufweist, so dass das erfindungsgemäße Bauelement sowohl zur Messung von kurzfristigen Druckschwankungen, insbesondere Schallwellen, einsetzbar ist, als auch zur Messung von statischen Druckzuständen, wie es bei einem Absolutdrucksensor oder einem Relativdrucksensor notwendig ist.

Erfindungsgemäß ist ferner bevorzugt, dass zeitlich vor und/oder nach der Herstellung der die Membranstruktur bildenden Schicht Prozessschritte zur Herstellung der monolithisch integrierten Schaltung durchgeführt werden. Hierdurch ist es erfindungsgemäß vorteilhaft möglich, dass eine Auswerteschaltung oder eine Ansteuerungsschaltung für das mikromechanische Bauelement direkt auf dem Substrat monolithisch integriert vorgesehen sein kann, so dass die Herstellung des Bauelements erheblich vereinfacht und kostengünstiger gestaltet wird.

Ferner ist es erfindungsgemäß bevorzugt, dass im Bereich der Membranstruktur aufgebrachte Deckschichten zumindest teilweise entfernt werden bzw. dass wenigstens eine Ausnehmung in die Membranstruktur eingebracht wird. Hierdurch kann die mechanische Stabilität der Membranstruktur sowie ihre Durchlässigkeit den jeweiligen Anforderungen der Anwendung angepasst werden.

Ein weiterer Gegenstand der vorliegenden Erfindung ist ein mikromechanisches Bauelement, insbesondere ein Mikrofon, ein Mikrolautsprecher oder ein Drucksensor, welches gemäß dem erfindungsgemäßen Verfahren herstellbar ist und wobei die Membranstruktur und zumindest ein Teilbereich des Substrats als eine Kondensatoranordnung aufweist. Hierdurch können besonders kleine Membranabstände zu dem Teilbereich des Substrats realisiert werden, was zu einer besonders hohen Empfindlichkeit des mikromechanischen Bauelements führt. Erfindungsgemäß ist insbesondere bevorzugt, dass der Abstand der Membranstruktur von dem Teilbereich des Substrats kleiner als etwa 10 µm, bevorzugt kleiner als 5 µm, besonders bevorzugt kleiner als etwa 2 µm und ganz besonders bevorzugt kleiner als etwa 1 µm. Hierdurch ist es zum einen möglich, die Membranstruktur an den jeweiligen Einsatzbereich des Bauelementes anzupassen und zum anderen eine hohe Empfindlichkeit des Bauelements zu erzielen.

Erfindungsgemäß weist die Membranstruktur eine erste Elektrode und der Teilbereich des Substrats eine zweite Elektrode auf, wobei die erste Elektrode und/oder die zweite Elektrode durch wenigstens eine Passivierungsschicht geschützt ist. Hierdurch kann das mikromechanische Bauelement einem Medium ausgesetzt werden, in welchem beispielsweise der Druck gemessen wird bzw. in welchem akustische Wellen detektiert bzw. angeregt werden sollen. Durch einen solchen Medienkontakt wird dabei vorteilhafterweise die erste bzw. die zweite Elektrode nicht durch ein gegebenenfalls aggressives Medium angegriffen.

Erfindungsgemäß ist weiterhin bevorzugt, dass die Membranstruktur zusammen mit einer in oder auf dem Substrat monolithisch integrierten Schaltung vorgesehen ist bzw. dass die Membranstruktur durchgehend vorgesehen ist bzw. dass die Membranstruktur Ausnehmungen aufweist. Hierdurch ist es besonders einfach möglich das mikromechanische Bauelement für eine Vielzahl von Anwendungsfällen anzupassen, beispielsweise für einen Absolut- oder Relativdrucksensor mit einer durchgehend vorgesehenen Membranstruktur (ohne Ausnehmungen bzw. Löcher) bzw. für akustische Anwendungen, bei denen ein Druckausgleich zwischen beiden Seiten der Membranstruktur vorteilhaft ist und daher die Membranstruktur Ausnehmungen bzw. Löcher aufweist. Ferner kann die monolithisch integrierbare Schaltung zusammen mit dem mikromechanischen Bauelement entweder monolithisch integriert vorgesehen sein oder auch separat vorgesehen sein, so dass beispielsweise eine Vielzahl von erfindungsgemäßen Bauelementen mit einer separaten Schaltung verbunden sein können.

Erfindungsgemäss sind die Teilbereiche und die Elektroden allseitig von wenigstens einer Passivierungsschicht umgeben und die Wände der Ausnehmungen und die zweite Seite des Substrats von wenigstens einer Passivierungsschicht bedeckt. Hierdurch wird eine besonders gute Langzeitstabilität und Medienbeständigkeit der gesamten Sensoranordnung bzw. des Bauelements erzielt.

Ausführungsbeispiele der Erfindung sind in der Zeichnung dargestellt und in der nachfolgenden Beschreibung näher erläutert.

### Kurze Beschreibung der Zeichnungen

Es zeigen
- **Figur 1**: eine schematische Darstellung eines erfindungsgemäßen Bauelements in Draufsicht,
- **Figuren 2 bis 7**: Vorläuferstrukturen des erfindungsgemäßen Bauelements zur Veranschaulichung des erfindungsgemäßen Verfahrens in Schnittdarstellung,
- **Figur 8**: ein erfindungsgemäßes Bauelement in Schnittdarstellung
- **Figur 9**: eine Vorläuferstruktur des erfindungsgemäßen Bauelements gemäß einer Ausführungsvariante und
- **Figur 10**: ein erfindungsgemäßes Bauelement gemäß einer Variante der Erfindung in Schnittdarstellung.

### Ausführungsformen der Erfindung

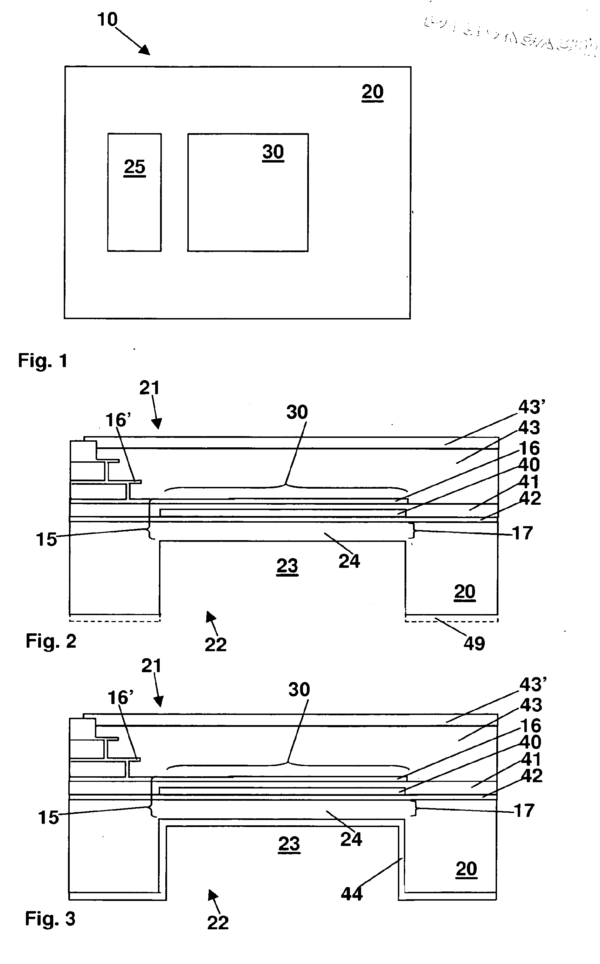

In **Figur 1** ist eine schematische Darstellung eines erfindungsgemäßen mikromechanischen Bauelements 10 in Draufsicht dargestellt. Das Bauelement 10 weist ein Substrat 20 und eine Membranstruktur 30 auf. Insbesondere ist es erfindungsgemäß vorgesehen, dass mit der Membranstruktur 30 eine Schaltung 25 monolithisch integriert in oder auf dem Substrat 20 vorgesehen ist. Eine solche Schaltung 25 kann beispielsweise eine Auswerteschaltung oder eine Ansteuerungsschaltung oder auch eine kombinierte Auswerteschaltung und/oder eine Ansteuerungsschaltung für die Membranstruktur 30 bzw. für das mikromechanische Bauelement 10 sein. Mittels der Membranstruktur 30 realisiert das Bauelement 10 insbesondere einen Drucksensor für Relativdrücke bzw. Absolutdrücke und/oder eine Struktur zur Detektion bzw. eine Aktuatorstruktur für akustische Wellen. Hierdurch ist es möglich, das Bauelement 10 beispielsweise als Mikrofon oder als Mikrolautsprecher einzusetzen.

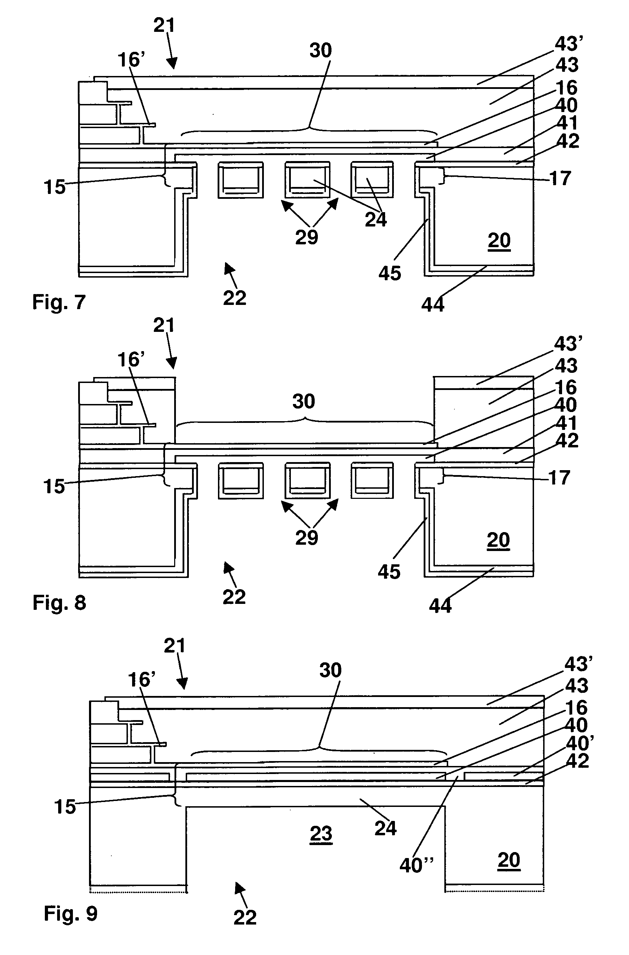

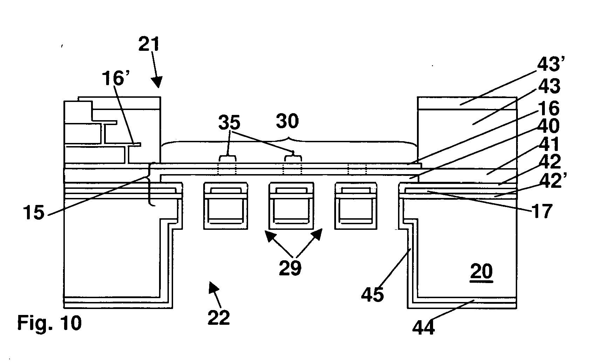

In den **Figuren 2 bis 10** sind Schnittdarstellungen durch Vorläuferstrukturen des Bauelements 10 bzw. durch das Bauelement 10 dargestellt. Die **Figuren 2 bis 7** **sowie 9** zeigen hierbei Vorläuferstrukturen des Bauelements 10, welches in **Figur 8** dargestellt ist bzw. in **Figur 10** in einer Variante dargestellt ist. Die Vorläuferstrukturen dienen hierbei der Veranschaulichung des erfindungsgemäßen Herstellungsverfahrens. **Figur 2** zeigt eine erste Vorläuferstruktur, bei der auf einer ersten Seite 21 des Substrats 20 eine dielektrische Schicht abgeschieden wurde, beispielsweise eine Siliziumoxidschicht, welche nachfolgend als zweite Passivierungsschicht 42 bezeichnet wird. Nach der zweiten Passivierungsschicht 42 wird eine Opferschicht bzw. eine Opferstruktur 40 aufgebracht und strukturiert. Diese Opferstruktur 40 bzw. diese Opferschicht 40 weist beispielsweise im wesentlichen polykristallines Silizium auf, welches auf der zweiten Passivierungsschicht 42 in strukturierter Weise aufgebracht wurde, beispielsweise mittels eines CVD-Verfahrens (chemical vapor deposition). Auf die Opferstruktur 40 wird eine weitere dielektrische Schicht 41 aufgebracht, welche im folgenden auch als erste Passivierungsschicht 41 bezeichnet wird. Die erste Passivierungsschicht 41 bildet zumindest im Bereich der Opferstruktur 40 einen Teil der Membranstruktur 30 aus. Oberhalb der ersten Passivierungsschicht 41 wird wenigstens eine elektrisch leitfähige Schicht als erste Elektrode 16 abgeschieden. Auf der ersten Elektrode 16 können erfindungsgemäß weitere Deckschichten aufgebracht werden, die bei der Herstellung der elektrischen oder elektronischen Schaltung 25 in einem anderem Teilbereich des Substrats 20 benötigt werden.

Diese weiteren Deckschichten werden im folgenden zusammenfassend mit dem Bezugszeichen 43 bezeichnet, wobei das Bezugszeichen 43' insbesondere eine abschließende passivierende Abdeckschicht bezeichnet, beispielsweise aus Siliziumnitrid. Die weiteren Schichten 43 weisen insbesondere Siliziumoxid auf, können jedoch auch eine sogenannte Mehrlagenmetallisierung 16` umfassen, wobei eine Mehrlagenmetallisierung 16` zum niederohmigen Anschluss der ersten Elektrode 16 dient. Von einer zweiten Seite 22 des Substrats 20 her, wobei die zweite Seite 22 der ersten Seite 21 gegenüberliegt, kann eine Kaverne 23 in das Substrat 20 eingebracht werden, um beispielsweise eine Gegenplatte 24 zur Membranstruktur 30 zu bilden, welche in einem Teilbereich 24 des Substrats, gegenüber der Membranstruktur 30 vorgesehen sein kann. Zur Erzeugung der Kaverne 23 wird insbesondere eine Ätzmaske 49 (gestrichelt dargestellt) auf der zweiten Seite 22 erzeugt und anschließend die Kaverne 23 mittels eines Ätzverfahrens hergestellt. Durch das elektrisch leitfähige Material des Substrats 20 wird durch den Teilbereich 24 des Substrats 20 eine zweite Elektrode 17 realisiert, so dass sich aus der ersten Elektrode 16 und der zweiten Elektrode 17 eine Kondensatoranordnung 15 ergibt. In der Vorläuferstruktur gemäß der Figur 2 ist die Membranstruktur 30 noch nicht vollständig fertiggestellt, weil die Opferstruktur 40 noch vorhanden ist.

Zur Herstellung der Membranstruktur 30 sind in den **Figuren 3 bis 7** weitere Vorläuferstrukturen des erfindungsgemäßen Bauelementes 10 dargestellt.

In der **Figur 9** ist eine zu der Figur 2 analoge Darstellung für eine weitere Variante des erfindungsgemäßen Bauelements 10 dargestellt. Hierbei ist die Schicht der Opferstruktur 40 nicht lediglich auf dem Bereich der Membranstruktur 30 beschränkt, sondern es findet sich das Material der Opferstruktur auch in einem weiteren Bereich des Bauelementes 10. Jedoch ist das Material der Opferstruktur 40 derart strukturiert aufgebracht dargestellt, dass zwischen der Opferstruktur 40 und den weiteren Stellen 40' eine Trennstruktur 40" vorgesehen ist, so dass die Opferstruktur 40 in allen ihren Abmessungen, das heißt auch hinsichtlich ihrer Breite, durch die Strukturierung des Materials der Opferstruktur 40 definiert ist. Dies gilt auch für die in Figur 2 dargestellte Variante des Bauelements 10. Hierdurch ist es erfindungsgemäß mittels eines isotropen Ätzvorganges nachfolgend möglich, dass die Opferstruktur 40 vollständig entfernt wird, wodurch eine definierte Membranstruktur 30 erfindungsgemäß realisierbar ist, d.h. mit vergleichsweise genau definierten Abmessungen hinsichtlich ihres Abstandes zum Teilbereich 24 des Substrats 20 sowie hinsichtlich ihrer Breite. Die weiteren Teile der Figur 2 sind auch in der Figur 9 vorgesehen und werden daher nicht nochmals eigens angesprochen.

In **Figur 3** ist eine zweite Vorläuferstruktur des erfindungsgemäßen Bauelementes 10 dargestellt. Hierbei ist gegenüber der ersten Vorläuferstruktur (vergleiche Figur 2 bzw. Figur 9) auf der zweiten Seite 22 des Substrats 20 eine dritte Passivierungsschicht 44, insbesondere eine Siliziumoxidschicht bzw. generell eine Oxidschicht, aufgebracht. Diese dritte Passivierungsschicht ist insbesondere auf die Wände der Kaverne 23 aufgebracht, welche in Figur 3 im wesentlichen senkrecht verlaufend dargestellt sind. Durch die dritte Passivierungsschicht 44 ist es möglich, die Kavernenwände vor einem Ätzangriff zu schützen. Weiterhin dient die dritte Passivierungsschicht 44 als Medienschutz für den Teilbereich 24 des Substrats 20, welcher bei einer akustischen Anwendung des Bauelementes 10 als Gegenelektrode bzw. als Gegenelement für die akustisch sensitive bzw. akustisch aktuierte Membranstruktur 30 herangezogen wird.

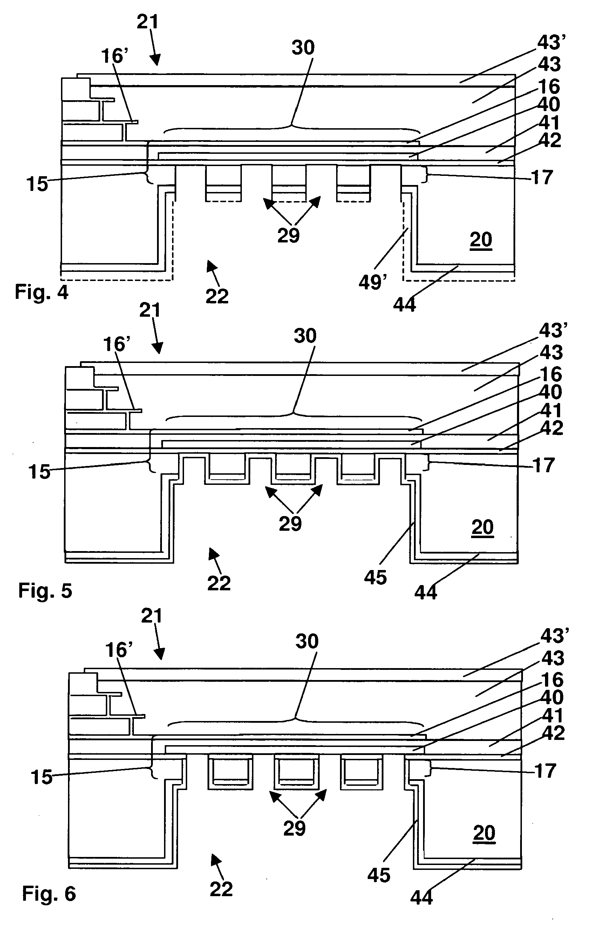

In **Figur 4** ist eine dritte Vorläuferstruktur des erfindungsgemäßen Bauelementes 10 dargestellt, wobei die dritte Vorläuferstruktur nach der Durchführung eines Ätzvorgangs von der zweiten Seite 22 des Substrats 20 her dargestellt ist. Hierzu ist auf der zweiten Seite 22 eine weitere Ätzmaske 49' mit gestrichelter Darstellung dargestellt. An den Stellen, an denen diese weitere Ätzmaske 49' Öffnungen aufweist, wird durch die dritte Passivierungsschicht 44 hindurch und durch den Teilbereich 24 des Substrats 20 hindurch Öffnungen 29 in das Substrat 20 bis zur zweiten Passivierungsschicht 42 hin eingebracht.

In **Figur 5** ist eine vierte Vorläuferstruktur des erfindungsgemäßen Bauelement 10 dargestellt, wobei auf der zweiten Seite 22 des Substrats 20 eine vierte Passivierungsschicht 45 aufgebracht wurde. Hierdurch wird insbesondere die senkrecht verlaufenden Wände der Öffnungen 29 passiviert, so dass die resultierende Anordnung gegenüber einem Medienkontakt resistenter ist.

In **Figur 6** ist eine fünfte Vorläuferstruktur des Bauelements dargestellt, wobei bei der fünften Vorläuferstruktur von der zweiten Seite 22 des Substrats 20 her ein weiterer Ätzschritt durchgeführt wurde, der die zweite Passivierungsschicht 42 und die vierte Passivierschicht 45 entfernt. Hierzu wird insbesondere ein anisotroper Ätzschritt beispielsweise ein Plasmaätzschritt oder ein lonenstrahlätzschritt verwendet, der zur Entfernung der freiliegenden zweiten und vierten Passivierungsschritt 42, 45 geeignet ist.

In **Figur 7** ist eine sechste Vorläuferstruktur des Bauelements 10 dargestellt, bei der die Opferstruktur 40 entfernt wurde, insbesondere mittels eines Gasphasen-Ätzprozesses, beispielsweise mit ClF₃. Erkennbar ist, dass die zweite Passivierungsschicht 42, die dritte Passivierungsschicht 44 und die vierte Passivierungsschicht 45 den Teilbereich 24 des Substrats 20 bzw. des Gegenelements trotz der Öffnungen 29 in diesem Teilbereich 24 vollständig abdeckt und damit passiviert.

In **Figur 8** ist das erfindungsgemäße Bauelement 10 dargestellt, bei dem gegenüber der Figur 7 die im Membranbereich 30 oberhalb der ersten Elektrode 16 noch verbliebenen Deckschichten entfernt wurden. Alternativ zu einer vollständigen Entfernung dieser Deckschichten kann es selbstverständlich auch vorgesehen sein, dass ein Teil der Deckschichten 43 in diesem Bereich stehen bleiben. Insbesondere ist es erfindungsgemäß vorgesehen, dass die erste Elektrode 16 auch hinsichtlich ihrer Oberseite mittels einer (nicht dargestellten) Abdeckschicht passiviert vorgesehen ist.

Das erfindungsgemäße Bauelement 10 kann beispielsweise eine, wie in Figur 1 dargestellt, quadratische oder eckiger Form der Membranstruktur 40 (in Draufsicht) aufweisen oder eine runde, ovale oder sonstige Form der Membranstruktur 40 aufweisen. Ferner können die Öffnungen 29 als runde, eckige, quadratische, rechteckige oder ovale Öffnungen 29 vorgesehen sein (Draufsicht).

Bei dem Substrat 20 handelt es sich insbesondere um ein Halbleitersubstrat, bevorzugt ein Siliziumsubstrat, wobei ein solches Siliziumsubstrat bevorzugt durchgehend oder zumindest in Teilbereichen dotiert vorgesehen sein kann. Besonders im Teilbereich 24 des Substrats 20, welcher gegenüber der Membranstruktur 30 angeordnet ist, kann es erfindungsgemäß vorteilhaft vorgesehen sein, dass eine Dotierung zur Herstellung einer vergleichsweise niederohmigen Verbindung zwischen dem Teilbereich 24 und einer nicht dargestellten Anschlusskontaktfläche zur elektrischen Kontaktierung vorgesehen ist. In den Figuren ist es nicht dargestellt, dass die Membranstruktur 30 ihrerseits Öffnungen aufweisen kann, um, insbesondere für akustische Anwendungen, einen Druckausgleich auf beiden Seiten der Membranstruktur 30 zuzulassen.

Erfindungsgemäß ist es vorgesehen, das der Spalt zwischen der Membranstruktur 30 und des Teilbereichs 34 des Substrats 20 besonders klein ist und besonders genau reproduzierbar ist. Hierdurch ist es möglich, dass ein geringer Abstand zwischen den Elektroden 16, 17 des Bauelements 10 und damit einhergehend eine große Empfindlichkeit realisierbar ist. Insbesondere sind hierbei Elektrodenabstände der Elektroden 16, 17 von unterhalb von 2 µm möglich. Bei dem Teilbereich 24 handelt es sich ebenfalls im wesentlichen um eine Membran, die jedoch erheblich dicker als die Membranstruktur 30 vorgesehen ist. Hierdurch ist der Teilbereich 24 erheblich massereicher als die Membranstruktur 30 und kann daher für akustische Anwendungen als Gegenelement bzw. Rückplatte der Membranstruktur 30 genutzt werden.

Die Ausbildung einer Schaltung, insbesondere einer Auswerteschaltung, in dem Substrat 20 ermöglicht es, eine teuere Mehrchiplösung zu vermeiden.

Gemäß einer Variante der Erfindung, wie sie in **Figur 10** in Schnittdarstellung schematisch dargestellt ist, kann die zweite Elektrode 17 auch dergestalt realisiert sein, dass auf der ersten Seite des Substrats 20 zunächst eine fünfte Passivierungsschicht 42', anschließend eine leitende Schicht zur Bildung der Elektrode 17 (beispielsweise eine Metallschicht oder auch eine dotierte und damit leitfähige Polysiliziumschicht) und daran anschließend wiederum die zweite Passivierungsschicht 42 abgeschieden wird. Die weiteren Herstellungsschritte bleiben wie zuvor beschrieben.

Eine weitere, zwar ebenfalls in **Figur 10** dargestellte, jedoch von der Gestaltung der zweiten Elektrode 17 unabhängige Variante der Erfindung betrifft die Einbringung von lediglich mittels gestrichelter Linie angedeuteten Ausnehmungen 35 in die Membranstruktur 30, beispielsweise für akustische Anwendungen.

## Patentansprüche

1. Verfahren zur Herstellung eines mikromechanischen Bauelements (10),
insbesondere eines Mikrofons, eines Mikrolautsprechers oder eines Drucksensors, mit einem Substrat (20) und mit einer Membranstruktur (30), wobei
- zur Herstellung der Membranstruktur (30) lediglich mit einer in oder auf dem Substrat (20) monolithisch integrierten Schaltung (25) kompatible Prozessschritte vorgesehen sind, und
- zur Bildung einer ersten Elektrode (16) auf einer ersten Seite (21) des Substrats (20) auf einer zweiten Passivierungsschicht (42) ein Opferschichtbereich (40) erzeugt und von einer ersten Passivierungsschicht (41), einer ersten Elektrode (16) und weiterer Deckschichten (43) abgedeckt wird, und
- zur Bildung einer zweiten Elektrode (17) in oder auf einem Teilbereich (24) des Substrats (20) gegenüber der Membranstruktur (30) von einer der ersten Seite (21) gegenüberliegenden zweiten Seite (22) des Substrats (20) aus
o eine Kaverne (23) in das Substrat (20) eingebracht wird, und
o eine dritte Passivierungsschicht (44) auf die Wände der Kaverne und den Teilbereich (24) des Substrats (20) aufgebracht wird, und
o durch wenigstens einen Ätzschritt Ausnehmungen (29) im Substrat (20) erzeugt werden, die von der Kaverne (23) bis auf die zweite Passivierungsschicht (42) reichen, wobei anschließend eine vierte Passivierungsschicht (45) zum Schutz der freigelegten im wesentlichen senkrecht zur Haupterstreckungsebene der Membranstruktur (20) verlaufenden Wände des Substrats (20) abgeschieden wird, und
o der Opferschichtbereich (40), nach dem Entfernen der zweiten und vierten Passivierungsschicht (42, 45) am Ende der Ausnehmungen (29) von der zweiten Seite (22) aus, entfernt wird,
wobei
die zweite, dritte und vierte Passivierungsschicht (42, 44, 45) derart abgeschieden werden,
dass sie die Oberfläche des Teilbereichs (24) mit der zweiten Elektrode (17) vollständig abdecken.

2. Verfahren nach Anspruch 1, **dadurch gekennzeichnet, dass** zeitlich vor und/oder nach der Herstellung der die Membranstruktur (30) bildenden Schicht Prozessschritte zur Herstellung der monolithisch integrierten Schaltung (25) durchgeführt werden.

3. Verfahren nach einem der vorhergehenden Anspruche, **dadurch gekennzeichnet, dass** im Bereich der Membranstruktur (30) aufgebrachte Deckschichten (43, 43') zumindest teilweise entfernt werden.

4. Verfahren nach einem der vorhergehenden Anspruche, **dadurch gekennzeichnet, dass** wenigstens eine Ausnehmung (35) in die Membranstruktur (30) eingebracht wird.

5. Verfahren nach einem der vorhergehenden Ansprüche, **dadurch gekennzeichnet dass** zur Realisierung der zweiten Elektrode (17) das Substrat (20) elektrisch leitfähiges Material aufweist.

6. Verfahren nach einem der Ansprüche 1 bis 4, **dadurch gekennzeichnet dass** zur Bildung der zweiten Elektrode (17) auf der ersten Seite des Substrats (20) eine fünfte Passivierungsschicht (42') und anschließend eine leitende Schicht zur Bildung der zweiten Elektrode (17) und daran anschließend die zweite Passivierungsschicht (42) abgeschieden wird.

7. Mikromechanisches Bauelement (10), insbesondere ein Mikrofon, ein Mikrolautsprecher oder ein Drucksensor, mit einem Substrat (20) und mit einer Membranstruktur (30), wobei die Membranstruktur (30) und zumindest ein Teilbereich (24) des Substrats (20) oder eine auf dem Substrat aufgebrachte leitfähige Schicht (17) als eine Kondensatoranordnung (15) vorgesehen ist,
wobei
• sich die Kondensatoranordnung (15) durch eine eine erste Elektrode (16) aufweisende Membranstruktur (30) auf einer ersten Seite (21) des Substrats (20) und einen Teilbereich (24) des Substrats (20) gegenüber der Membranstruktur (30) als zweite Elektrode (17) ergibt, und
• die erste und zweite Elektrode durch wenigstens eine Passivierungsschicht (41, 42) geschützt ist, und
• das Substrat (20) eine Kaverne (23) mit im wesentlichen senkrecht zur Haupterstreckungsebene der Membranstruktur (20) verlaufenden Wände aufweist und
• auf die Wände der Kaverne und den Teilbereich (24) Substrats (20) eine dritte Passivierungsschicht (44) aufgebracht ist, und
• der Teilbereich (24) des Substrats (20) ausgehend von der kaverne (23) Offnungen (29) aufweist, wobei die im wesentlichen senkrecht zur Haupterstreckungsebene der Membranstruktur (20) verlaufende Wände im Substrat (20) eine vierte Passivierungsschicht (45) zum Schutz aufweisen,
so dass
die Oberfläche des Teilbereichs (24) und der Elektroden (16, 17) von wenigstens einer Passivierungsschicht (41, 42, 44, 45) umgeben sind.

8. Bauelement (10) nach Anspruch 7, **dadurch gekennzeichnet, dass** der Abstand der Membranstruktur (30) von dem Teilbereich (24) des Substrats (20) kleiner als etwa 10 µm ist, bevorzugt kleiner als etwa 5 µm, besonders bevorzugt kleiner als etwa 2 µm.

9. Bauelement (10) nach Anspruch 7 oder 8, **dadurch gekennzeichnet, dass** die Membranstruktur (30) eine erste Elektrode (16) und der Teilbereich (24) des Substrats (20) eine zweite Elektrode (17) aufweist, wobei die erste Elektrode (16) und/oder die zweite Elektrode (17) durch wenigstens eine Passivierungsschicht (41, 42, 44, 45) geschützt ist.

10. Bauelement (10) nach einem der Anspruche 7 bis 9, **dadurch gekennzeichnet, dass** die Membranstruktur (30) zusammen mit einer in oder auf dem Substrat (20) monolithisch integrierten Schaltung (25) vorgesehen ist.

11. Bauelement (10) nach einem der Anspruche 7 bis 9, **dadurch gekennzeichnet, dass** die Membranstruktur (30) durchgehend vorgesehen ist.

12. Bauelement (10) nach einem der Anspruche 7 bis 9, **dadurch gekennzeichnet, dass** die Membranstruktur (30) Ausnehmungen (35) aufweist.

13. Bauelement (10) nach einem der Anspruche 7 bis 12, **dadurch gekennzeichnet, dass** die Wände der Ausnehmungen (29) und die zweite Seite (22) des Substrats (20) von wenigstens einer Passivierungsschicht (41, 42, 44, 45) bedeckt sind.

## Claims

1. Method for producing a micromechanical component (10), in particular a microphone, a microloudspeaker or a pressure sensor, comprising a substrate (20) and comprising a membrane structure (30), wherein
- only process steps compatible with a circuit (25) monolithically integrated in or on the substrate (20) are provided for producing the membrane structure (30), and
- for forming a first electrode (16) on a first side (21) of the substrate (20) on a second passivation layer (42) a sacrificial layer region (40) is produced and covered by a first passivation layer (41), a first electrode (16) and further covering layers (43), and
- for forming a second electrode (17) in or on a partial region (24) of the substrate (20) opposite the membrane structure (30) from a second side (22) of the substrate (20), said second side lying opposite the first side (21),
° a cavity (23) is introduced into the substrate (20), and
° a third passivation layer (44) is applied to the walls of the cavity and the partial region (24) of the substrate (20), and
° cutouts (29) are produced in the substrate (20) by means of at least one etching step, said cutouts extending from the cavity (23) as far as the second passivation layer (42), wherein a fourth passivation layer (45) for protecting the uncovered walls of the substrate (20) that run substantially perpendicularly to the main extension plane of the membrane structure (30) is subsequently deposited, and
° the sacrificial layer region (40) is removed after the removal of the second and fourth passivation layers (42, 45) at the end of the cutouts (29) from the second side (22),
wherein
the second, third and fourth passivation layers (42, 44, 45) are deposited in such a way that they completely cover the surface of the partial region (24) with the second electrode (17).

2. Method according to Claim 1, **characterized in that** process steps for producing the monolithically integrated circuit (25) are carried out temporally before and/or after the production of the layer forming the membrane structure (30).

3. Method according to either of the preceding claims, **characterized in that** covering layers (43, 43') applied in the region of the membrane structure (30) are at least partly removed.

4. Method according to any of the preceding claims, **characterized in that** at least one cutout (35) is introduced into the membrane structure (30).

5. Method according to any of the preceding claims, **characterized in that**, for realizing the second electrode (17), the substrate (20) comprises electrically conductive material.

6. Method according to any of Claims 1 to 4, **characterized in that** for forming the second electrode (17) on the first side of the substrate (20) a fifth passivation layer (42') and then a conductive layer for forming the second electrode (17) and subsequently the second passivation layer (42) are deposited.

7. Micromechanical component (10), in particular a microphone, a microloudspeaker or a pressure sensor, comprising a substrate (20) and comprising a membrane structure (30), wherein the membrane structure (30) and at least one partial region (24) of the substrate (20) or a conductive layer (17) applied on the substrate are provided as a capacitor arrangement (15),
wherein
• the capacitor arrangement (15) results from a membrane structure (30) having a first electrode (16) on a first side (21) of the substrate (20) and a partial region (24) of the substrate (20) opposite the membrane structure (30) as second electrode (17), and
• the first and second electrodes are protected by at least one passivation layer (41, 42), and
• the substrate (20) has a cavity (23) having walls running substantially perpendicularly to the main extension plane of the membrane structure (30),
• a third passivation layer (44) is applied to the walls of the cavity and the partial region (24) of the substrate (20), and
• the partial region (24) of the substrate (20) has openings (29) proceeding from the cavity (23), wherein the walls running substantially perpendicularly to the main extension plane of the membrane structure (30) in the substrate (20) have a fourth passivation layer (45) for protection,
such that
the surface of the partial region (24) and of the electrodes (16, 17) are surrounded by at least one passivation layer (41, 42, 44, 45).

8. Component (10) according to Claim 7, **characterized in that** the distance between the membrane structure (30) and the partial region (24) of the substrate (20) is less than approximately 10 µm, preferably less than approximately 5 µm, particularly preferably less than approximately 2 µm.

9. Component (10) according to Claim 7 or 8, **characterized in that** the membrane structure (30) has a first electrode (16) and the partial region (24) of the substrate (20) has a second electrode (17), wherein the first electrode (16) and/or the second electrode (17) are/is protected by at least one passivation layer (41, 42, 44, 45).

10. Component (10) according to any of Claims 7 to 9, **characterized in that** the membrane structure (30) is provided together with a circuit (25) monolithically integrated in or on the substrate (20).

11. Component (10) according to any of Claims 7 to 9, **characterized in that** the membrane structure (30) is provided in continuous fashion.

12. Component (10) according to any of Claims 7 to 9, **characterized in that** the membrane structure (30) has cutouts (35).

13. Component (10) according to any of Claims 7 to 12, **characterized in that** the walls of the cutouts (29) and the second side (22) of the substrate (20) are covered by at least one passivation layer (41, 42, 44, 45).

## Revendications

1. Procédé de fabrication d'un composant micromécanique (10), en particulier d'un microphone, d'un micro-haut-parleur ou d'une sonde de pression, le composant présentant un substrat (20) et une structure à membrane (30),
seules des étapes de traitement compatibles avec un circuit intégré monolithique (25) présent dans ou sur le substrat (20) étant prévues pour fabriquer la structure à membrane (30),
pour former une première électrode (16) sur un premier côté (21) du substrat (20), une partie de couche sacrifiée (40) étant formée sur une deuxième couche de passivation (42) et étant recouverte par une première couche de passivation (41), une première électrode (16) et d'autres couches de recouvrement (43) et
pour former une deuxième électrode (17) dans ou sur une partie (24) du substrat (20) située face à la structure de membrane (30), depuis un deuxième côté (22) du substrat (20) situé face au premier côté (21), une cavité (23) étant formée dans le substrat (20), et
une troisième couche de passivation (44) étant appliquée sur les parois de la cavité et la partie (24) du substrat (20),
des découpes (29) qui s'étendent depuis la cavité (23) jusqu'à la deuxième couche de passivation (42) étant formées dans le substrat (20) par au moins une étape de gravure, une quatrième couche de passivation (45) servant à protéger les parois du substrat (20) exposées et s'étendant essentiellement à la perpendiculaire du plan d'extension principale de la structure à membrane (30) étant déposée et
la partie de couche sacrifiée (40) étant enlevée à l'extrémité des découpes (29) et depuis le deuxième côté (22) après l'enlèvement de la deuxième et de la quatrième couche de passivation (42, 45),
la deuxième, la troisième et la quatrième couche de passivation (42, 44, 45) étant déposées de telle sorte qu'elles couvrent complètement la surface de la partie (24) qui présente la deuxième électrode (17).

2. Procédé selon la revendication 1, **caractérisé en ce que** les étapes de traitement destinées à réaliser le circuit intégré monolithique (25) sont exécutées avant et/ou après la réalisation de la couche qui forme la structure à membrane (30).

3. Procédé selon l'une des revendications précédentes, **caractérisé en ce que** les couches de recouvrement (43, 43') appliquées au niveau de la structure à membrane (30) sont enlevées au moins en partie.

4. Procédé selon l'une des revendications précédentes, **caractérisé en ce qu'**au moins une découpe (35) est ménagée dans la structure à membrane (30).

5. Procédé selon l'une des revendications précédentes, **caractérisé en ce que** pour réaliser la deuxième électrode (17), le substrat (20) présente un matériau électriquement conducteur.

6. Procédé selon l'une des revendications 1 à 4, **caractérisé en ce que** pour former la deuxième électrode (17), une cinquième couche de passivation (42') est déposée sur le premier côté du substrat (20), une couche conductrice destinée à former la deuxième électrode (17) étant déposée ensuite, suivie par la deuxième couche de passivation (42).

7. Composant micromécanique (10), en particulier microphone, micro-haut-parleur ou sonde de pression, présentant un substrat (20) et une structure à membrane (30), la structure à membrane (30) et au moins une partie (24) du substrat (20) ou une couche conductrice (17) appliquée sur le substrat étant prévues pour former un ensemble de condensateur (15),
l'ensemble de condensateur (15) étant formé d'une structure à membrane (30) qui présente une première électrode (16) sur un premier côté (21) du substrat (20) et une partie (24) du substrat (20) située face à la structure à membrane (30) servant de deuxième électrode (17),
la première et la deuxième électrode étant protégées par au moins une couche de passivation (41, 42),
le substrat (20) présentant une cavité (23) dont les parois s'étendent essentiellement à la perpendiculaire du plan d'extension principale de la structure à membrane (30),
une troisième couche de passivation (44) étant appliquée sur les parois de la cavité et sur la partie (24) du substrat (20), la partie (24) du substrat (20) présentant des ouvertures (29) qui partent de la cavité (23), les parois s'étendant essentiellement à la perpendiculaire du plan d'extension principale de la structure à membrane (30) présentant dans le substrat (20) une quatrième couche de passivation (45) à des fins de protection
de telle sorte que la surface de la partie (24) et des électrodes (16, 17) soit entourée par au moins une couche de passivation (41, 42, 44, 45).

8. Composant (10) selon la revendication 7, **caractérisé en ce que** la distance entre la structure à membrane (30) et la partie (24) du substrat (20) est inférieure à environ 10 µm, de préférence inférieure à environ 5 µm et de façon particulièrement préférable inférieure à environ 2 µm.

9. Composant (10) selon les revendications 7 ou 8, **caractérisé en ce que** la structure à membrane (30) présente une première électrode (16) et la partie (24) du substrat (20) une deuxième électrode (17), la première électrode (16) et/ou la deuxième électrode (17) étant protégées par au moins une couche de passivation (41, 42, 44, 45).

10. Composant (10) selon l'une des revendications 7 à 9, **caractérisé en ce que** la structure à membrane (30) est prévue en même temps qu'un circuit intégré monolithique (25) dans ou sur le substrat (20).

11. Composant (10) selon l'une des revendications 7 à 9, **caractérisé en ce que** la structure à membrane (30) est continue.

12. Composant (10) selon l'une des revendications 7 à 9, **caractérisé en ce que** la structure à membrane (30) présente des découpes (35).

13. Composant (10) selon l'une des revendications 7 à 12, **caractérisé en ce que** les parois des découpes (29) et le deuxième côté (22) du substrat (20) sont recouverts par au moins une couche de passivation (41, 42, 44, 45).
